# EUROPEAN PATENT APPLICATION

(11) **EP 3 569 732 A1**
(43) Date of publication of application: **20.11.2019**
(21) Application number: 19174673.4
(22) Date of filing: 15.05.2019
(51) Int. Cl.: C23C 16/40, C23C 16/455, C23C 28/04

(54) **CORROSION BARRIER**

(30) Priority: 17.05.2018 US 201815982290
(71) Applicant: Hamilton Sundstrand Corporation, Charlotte, NC 28217-4578 (US)
(72) Inventor: POTEET, Steven, 06518, Connecticut Hamden (US); GAGE, Marc E., Feeding Hills, Massachusetts 01030 (US); SHEEDY, Paul, Bolton, Connecticut 06043 (US); MAGDEFRAU, Neal, Tolland, Connecticut 06084 (US)
(74) Representative: Dehns

(57) **Abstract**

A method of applying a corrosion barrier includes applying a conversion coat (212) onto a component and applying a layer (214) of ceramic material over the conversion coat by atomic layer deposition. The conversion coat and the ceramic material provide corrosion resistance. A component with a corrosion barrier (200) is also disclosed.

## Description

### BACKGROUND

Many aerospace components, including gas turbine engine and air management system components, have corrosion barriers (coatings). Corrosion barriers improve the lifetime of the component by improving the corrosion resistance of the component. In particular, some components have non-line of sight surfaces, such as surfaces of internal passages or the like, which are subject to corrosion and benefit from corrosion barriers. In particular, crevices and small, complex features can serve as initiation sites for corrosion. It is difficult to uniformly apply corrosion barriers to non-line of sight surfaces such as the passages of a heat exchanger. Imperfections in the corrosion barrier can reduce its effectiveness in protecting the underlying component from corrosion as well as negatively impact the performance of the component.

### SUMMARY

A method of applying a corrosion barrier according to an example of the present disclosure includes applying a conversion coat onto a component and applying a layer of ceramic material over the conversion coat by atomic layer deposition. The conversion coat and the ceramic material provide corrosion resistance.

In a further embodiment according to any of the foregoing embodiments, the conversion coat is applied by dipping or tumbling.

In a further embodiment according to any of the foregoing embodiments, the ceramic material is hydrophobic or superhydrophobic.

In a further embodiment according to any of the foregoing embodiments, the ceramic material includes an element from the Lanthanide series.

In a further embodiment according to any of the foregoing embodiments, the layer of ceramic material is a first layer, and the method includes applying a second layer of ceramic material over the first layer of ceramic material by atomic layer deposition.

In a further embodiment according to any of the foregoing embodiments, the second layer of ceramic material is hydrophobic or superhydrophobic.

In a further embodiment according to any of the foregoing embodiments, the second layer of ceramic material comprises an element from the Lanthanide series.

In a further embodiment according to any of the foregoing embodiments, the layer of ceramic material includes at least one of an oxide, carbide, or nitride of at least one of aluminum, silicon, magnesium, titanium, chromium, manganese, iron, cobalt, nickel, copper, zinc, zirconium, niobium, molybdenum, hafnium, tantalum, tungsten, rare earth metals (e.g., metals of the Lanthanide series), and combinations thereof.

In a further embodiment according to any of the foregoing embodiments, the coating is applied to line of sight and non-line of sight surfaces of the component.

A method of applying a corrosion barrier according to an example of the present disclosure includes applying a first layer of ceramic material onto a component by atomic layer deposition and applying a second layer of ceramic material onto the component by atomic layer deposition. The second layer is hydrophobic or superhydrophobic, and the first and second layers of ceramic material provide corrosion resistance.

In a further embodiment according to any of the foregoing embodiments, the second layer is deposited over the first layer.

In a further embodiment according to any of the foregoing embodiments, the second layer comprises an element from the Lanthanide series.

In a further embodiment according to any of the foregoing embodiments, at least one of the first and second layers of ceramic material includes at least one of an oxide, carbide, or nitride of at least one of aluminum, silicon, magnesium, titanium, chromium, manganese, iron, cobalt, nickel, copper, zinc, zirconium, niobium, molybdenum, hafnium, tantalum, tungsten, rare earth metals (e.g., metals of the Lanthanide series), and combinations thereof.

In a further embodiment according to any of the foregoing embodiments, the applying is to line of sight and non-line of sight surfaces of the component.

A component according to an example of the present disclosure includes a base material and a corrosion barrier. The corrosion barrier includes an active corrosion barrier adjacent the base material and a unitary, homogenous ceramic layer over the active corrosion barrier.

In a further embodiment according to any of the foregoing embodiments, the corrosion barrier is on at least one of a line of sight surface and a non-line of sight surface of the component.

In a further embodiment according to any of the foregoing embodiments, the component is a heat exchanger.

In a further embodiment according to any of the foregoing embodiments, the ceramic layer has a thickness of between about 1 and 500 nanometers (0.00004 and 0.02 mils).

In a further embodiment according to any of the foregoing embodiments, the second ceramic layer is hydrophobic or superhydrophobic.

In a further embodiment according to any of the foregoing embodiments, the active corrosion barrier is a conversion coat.

### BRIEF DESCRIPTION OF THE DRAWINGS

Figure 1A schematically shows an example component.
Figure 1B schematically shows a cutaway view of the example component of Figure 1A.
Figure 1C schematically shows a detail view of the example component of Figures 1A-B.
Figure 2 schematically shows an example corrosion barrier.
Figure 3 schematically shows a method for atomic layer deposition.
Figure 4 schematically shows another example corrosion barrier.
Figure 5 schematically shows another example corrosion barrier.

The various features and advantages of the disclosed examples will become apparent to those skilled in the art from the following detailed description. The drawings that accompany the detailed description can be briefly described as follows.

### DETAILED DESCRIPTION

Many aerospace components, such as gas turbine engine and air management system components, have corrosion barriers. Some corrosion barriers include two layers a conversion coat and a top coat. An example conversion coat is a chromium-containing (chromated) coat, such as Permatreat® 686A (Chemetall, Auckland, New Zealand). The conversion coat is applied by dipping or tumbling the component in the coating material, and relying on air or gravity to remove excess coating material. Example topcoats are silicone or phenolic epoxy coatings, such as Rockhard (Indestructible Paint, Inc., Monroe, CT). These topcoats can contain high amounts of volatile organic components (VOCs), which are also subject to environmental regulations. The topcoats typically have a thickness on the order of 5-10 microns (0.2-0.4 mils).

The application of the conversion coat and topcoats can result in non-uniform coating layers, especially on non-line of site surfaces such as heat exchanger passages. The non-uniformity of the coating detracts from its ability to provide corrosion resistance. For example, jagged irregularities in the coating can serve as nucleation cites for acidic (e.g. sulfuric acid) corrosion of the underlying component. As another example, locations where the coating is deposited too thickly, for instance drips from the gravity-driven removal of excess conversion coating material, can cause the coating to chip away from the underlying component, leaving it exposed to a corrosive environment. The described coating non-uniformity can also influence the performance of the underlying components, for example, by affecting air or fluid flow through heat exchanger passages.

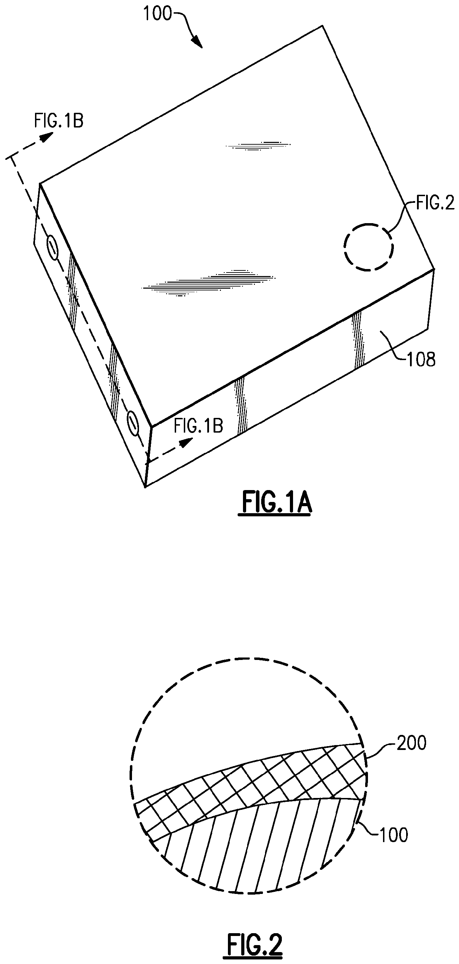

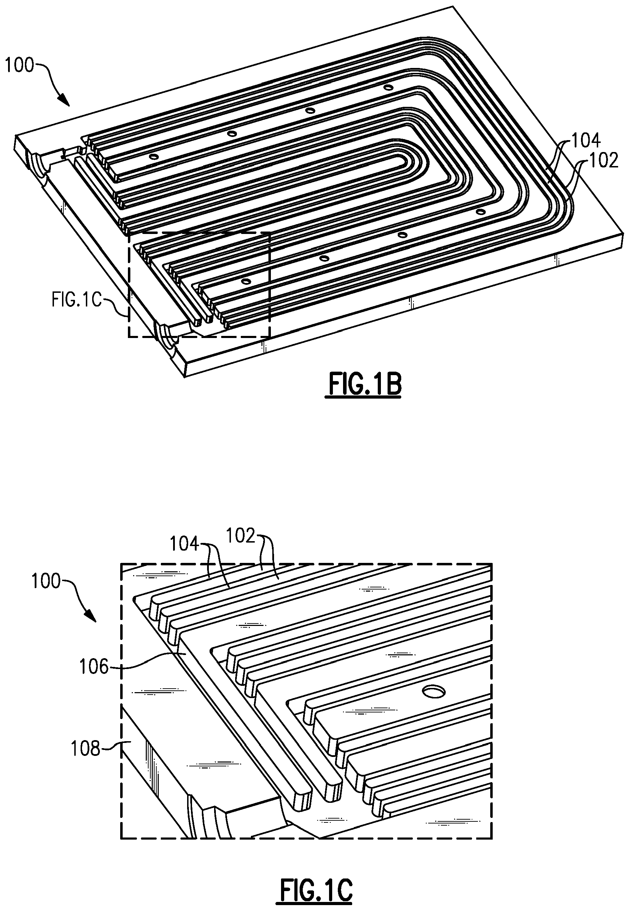

Turning now to Figures 1A-C, an example component 100 is shown. In one example, the component 100 base material comprised of a nickel-based material, an aluminum-based material, or steel, though other materials are contemplated.

In Figures 1A-C, the example component is a heat exchanger 100, though it should be understood the following description is not limited to heat exchangers. Heat exchanger 100 includes internal features, such as ribs or fins 102 that define passages 104. The internal features 102, 104, have surfaces 106 with a corrosion barrier, as will be discussed below. The surfaces 106 are non-line of site surfaces. Heat exchanger 100 also includes exterior or line of site surfaces 108. Other example components can have other non-line of site or line of site surfaces with the corrosion barrier.

Figure 2 shows corrosion barrier 200 on a surface of the heat exchanger 100. The surface can be one or both of non-line of site surface 106 or line of site surfaces 108. The corrosion barrier 200 includes one layer or multiple layers, discussed in more detail below. At least one of the layers is deposited by atomic layer deposition. In one example, an ALD-deposited layer can constitute a single material, but in other examples, an ALD-deposited layer can constitute multiple materials arranged in sub-layers, as will be discussed in more detail below.

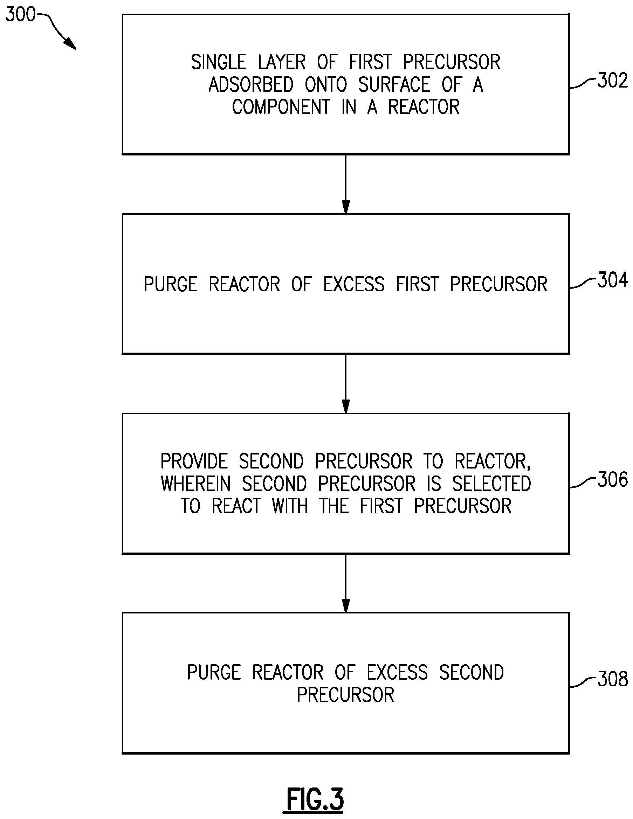

Figure 3 shows a method 300 for atomic layer deposition (ALD). In step 302, a single layer of a first precursor is adsorbed onto the surface of a component, such as the heat exchanger 100, in a reactor. In step 304, the reactor is purged of excess first precursor. In step 306, a second precursor is provided to the reactor, wherein the second precursor is selected to react with the adsorbed first precursor. In step 308, the reactor is purged of excess second precursor.

Adsorption of the first precursor in step 302 can be affected on non-line of site surfaces 106 as well as line of site surfaces 108 by exposing the heat exchanger 100 to the first precursor in a reactor. Accordingly, because the first precursor is introduced and adsorbed on the heat exchanger 100 in a single layer in step 302, and the second precursor reacts only with the adsorbed first precursor in step 306, the resulting deposition of material is a uniform (homogenous), continuous (unitary) layer, generally free of pinholes or other imperfections on both line of site surfaces 108 and non-line of site surfaces 106, along uneven or irregular areas, or areas with complex geometries. The ALD process can be automated, as compared to the dipping/or tumbling processes for the conversion coat discussed above, decreasing manufacturing costs and time.

Steps 302-308 can be repeated to provide a layer of a desired thickness for the corrosion barrier 200. In one example, steps 302-308 are repeated to provide a layer with a thickness of between about 1 and 500 nanometers (0.00004 and 0.02 mils). This is an order of magnitude or more less than the topcoat layer discussed above. As discussed above, in one example, the first and second precursors in successive repetitions of steps 302 and 306 are the same, providing an ALD layer of a single material. In another example, the first and second precursors can be changed in successive repetitions of steps 302 and 306 to provide sub-layers of different material in the ALD layer. For instance, sub-layers may be between 5 and 10 nanometers (0.0002 and 0.0004 mils) thick. In a particular example, the ALD layer comprises alternating sub-layers of materials such as Al₂O₃ and TiO₂ (or any of the materials discussed below), each of which are between 5 and 10 nanometers (0.0002 and 0.0004 mils) thick, built up to an ALD layer with thickness of between about 1 and 500 nanometers (0.00004 and 0.02 mils).

In one example, such as the example of Figure 2, the corrosion barrier 200 comprises the entire coating which is deposited by ALD as in method 300. In other words, the corrosion barrier 200 replaces both the conversion coat and the topcoat discussed above. The corrosion barrier 200 provides a barrier for preventing moisture and dissolved salts from reaching the component 100 and causing corrosion. The corrosion barrier 200 is a relatively thin, uniform (homogenous), and continuous (unitary) layer, even on non-line of sight surfaces of component 100. The corrosion barrier 200 is free from volatile organic components, like the topcoats discussed above. In one example, the corrosion barrier 200 is also free from forms of chromium which are subject to many environmental regulations.

The corrosion barrier 200 comprises a ceramic material, such as an oxide, carbide, or nitride of aluminum, silicon, magnesium, titanium, chromium, manganese, iron, cobalt, nickel, copper, zinc, zirconium, niobium, molybdenum, hafnium, tantalum, tungsten, rare earth metals (e.g., metals of the Lanthanide series), and combinations thereof. Particular example materials are TiO₂ (titanium dioxide), Ta₂O₅ (tantalum pentoxide), SiO₂ (silicon dioxide), Nb₂O₅ (niobium oxide), or Al₂O₃ (aluminum oxide). The specific material is selected according to the material of the component 100 and the operating environment of the component 100. For instance, certain materials are preferred for high humidity environments as compared to environments exposed to liquid water. Similarly, acidic environments may require more robust materials, such as Ta₂O₅ (tantalum pentoxide) or Nb₂O₅ (niobium oxide).

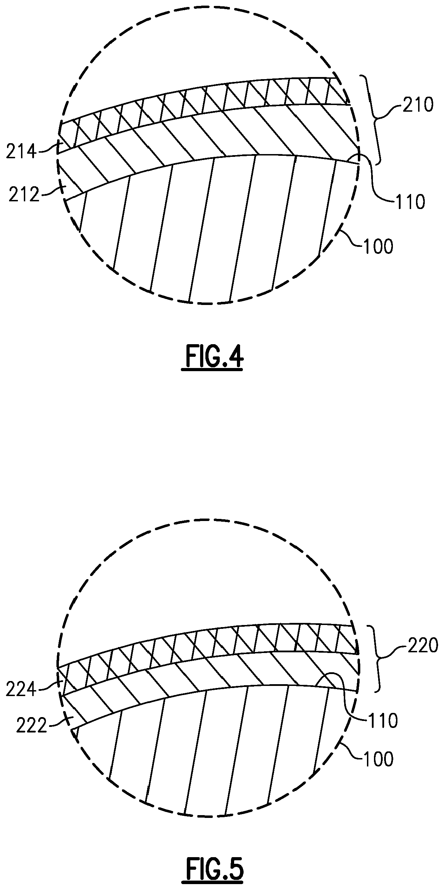

Figure 4 shows an example corrosion barrier 210 for a surface 110 of heat exchanger 100. The surface 110 can be either of the surfaces 106, 108 discussed above. In the example of Figure 4, the corrosion barrier 210 includes two layers 212, 214. The first, inner, layer 212 is adjacent the heat exchanger 100. In this example, the first layer 212 is a chromium-based layer, such as the conversion coat discussed above, or could be a chromate free conversion treatment. The second, outer layer 214 comprises a ceramic material deposited by ALD such as the ALD corrosion barrier 200 discussed above. In this example, the ALD layer 214 replaces the topcoat layer discussed above, and provides a uniform (homogenous), continuous (unitary) layer over the conversion coat layer, which may not be uniform or continuous for the reasons discussed above. The conversion coat layer 212 provides an active corrosion barrier in case of damage to the ALD layer 214. The active corrosion barrier is active in that it can undergo a chemical reaction that inhibits corrosion. For instance, if a chromium-based active corrosion barrier is damaged, chromate ions in a chromium-based active corrosion barrier can enter the damaged portion and react with surrounding electrolytes to form chromium oxide, which protects against corrosion. In this way, the active corrosion barrier is "self-healing." In other examples, the corrosion barrier 210 comprises more than one ALD layer 214 of the same or a different ceramic material, which is selected to provide desired corrosion-resistant properties to the component. In yet other examples, the topcoat layer discussed above is deposited on top of the ALD layer 214 to protect the ALD layer 214 from structural or mechanical damage. In this example, the ALD layer still provides a uniform (homogenous), continuous (unitary) layer over the conversion coat layer, which may not be uniform or continuous for the reasons discussed above.

Figure 5 shows another example corrosion barrier 220. In this example, the corrosion barrier 220 includes an inner ALD layer 222 and an outer ALD layer 224. One of the inner ALD layer 222 and the outer ALD layer 224 is similar to the ALD layers 200, 214 discussed above. The other of the ALD layer 222 and the outer ALD layer 224 is hydrophobic or superhydrophobic. In one example, the hydrophobic or superhydrophobic layer comprises an element from the Lanthanide series which imparts the hydrophobicity or superhydrophobicity to the layer. In a particular example, the hydrophobic or superhydrophobic layer is the outer ALD layer 224. The hydrophobicity/superhydrophobicity allows the ALD layer 224 to remove moisture from the surface 110, which is particularly important in preventing water buildup in small passages such as the passages 104 (Figure 1B-C). Furthermore, the hydrophobicity/superhydrophobicity prevents or contributes to the prevention of ice buildup. In one example, the hydrophobic/superhydrophobic layer 224 is between 1 and 10 nm (0.00004 and 0.0004 mils) thick.

In another example, the corrosion barrier 210 of Figure 4 further includes a hydrophobic or superhydrophobic outer layer in addition to the conversion coat layer 212 and the ALD layer 214. In yet another example, the ALD layer 214 in Figure 4 is a hydrophobic or superhydrophobic layer, as discussed above.

Although a combination of features is shown in the illustrated examples, not all of them need to be combined to realize the benefits of various embodiments of this disclosure. In other words, a system designed according to an embodiment of this disclosure will not necessarily include all of the features shown in any one of the Figures or all of the portions schematically shown in the Figures. Moreover, selected features of one example embodiment may be combined with selected features of other example embodiments. In other words, corrosion barriers comprising one or more of the various layers discussed above with respect to examples 200, 210, 220 is contemplated by this disclosure.

The preceding description is exemplary rather than limiting in nature. Variations and modifications to the disclosed examples may become apparent to those skilled in the art that fall within the scope of the invention as defined by the claims.

## Claims

1. A method of applying a corrosion barrier, comprising:
applying a conversion coat (212) onto a component; and
applying a layer (214) of ceramic material over the conversion coat by atomic layer deposition, wherein the conversion coat and the ceramic material provide corrosion resistance.

2. The method of claim 1, wherein the conversion coat is applied by dipping or tumbling.

3. The method of claim 1 or 2, wherein the ceramic material is hydrophobic or superhydrophobic, and preferably wherein the ceramic material comprises an element from the Lanthanide series, or wherein the layer of ceramic material comprises at least one of an oxide, carbide, or nitride of at least one of aluminum, silicon, magnesium, titanium, chromium, manganese, iron, cobalt, nickel, copper, zinc, zirconium, niobium, molybdenum, hafnium, tantalum, tungsten, rare earth metals (e.g., metals of the Lanthanide series), and combinations thereof.

4. The method of any preceding claim, wherein the layer of ceramic material is a first layer, and further comprising applying a second layer of ceramic material over the first layer of ceramic material by atomic layer deposition.

5. The method of claim 4, wherein the second layer of ceramic material is hydrophobic or superhydrophobic, and preferably wherein the second layer of ceramic material comprises an element from the Lanthanide series, or wherein the layer of ceramic material comprises at least one of an oxide, carbide, or nitride of at least one of aluminum, silicon, magnesium, titanium, chromium, manganese, iron, cobalt, nickel, copper, zinc, zirconium, niobium, molybdenum, hafnium, tantalum, tungsten, rare earth metals (e.g., metals of the Lanthanide series), and combinations thereof.

6. A method of applying a corrosion barrier, comprising:
applying a first layer (222) of ceramic material onto a component by atomic layer deposition; and
applying a second layer (224) of ceramic material onto the component by atomic layer deposition, wherein the second layer is hydrophobic or superhydrophobic, and wherein the first and second layers of ceramic material provide corrosion resistance.

7. The method of claim 6, wherein the second layer is deposited over the first layer.

8. The method of claim 6 or 7, wherein the second layer comprises an element from the Lanthanide series, or wherein at least one of the first and second layers of ceramic material comprises at least one of an oxide, carbide, or nitride of at least one of aluminum, silicon, magnesium, titanium, chromium, manganese, iron, cobalt, nickel, copper, zinc, zirconium, niobium, molybdenum, hafnium, tantalum, tungsten, rare earth metals (e.g., metals of the Lanthanide series), and combinations thereof.

9. The method of any preceding claim, wherein the applying is to line of sight (108) and non-line of sight (106) surfaces of the component.

10. A component, comprising:
a base material; and
a corrosion barrier (210), the corrosion barrier comprising an active corrosion barrier (212) adjacent the base material and a unitary, homogenous ceramic layer (214) over the active corrosion barrier.

11. The component of claim 10, wherein the corrosion barrier is on at least one of a line of sight surface (108) and a non-line of sight surface (106) of the component.

12. The component of claim 11, wherein the component is a heat exchanger.

13. The component of claim 10, 11 or 12, wherein the ceramic layer has a thickness of between about 1 and 500 nanometers (0.00004 and 0.02 mils).

14. The component of any of claims 10 to 13, wherein the second ceramic layer is hydrophobic or superhydrophobic.

15. The component of any of claims 10 to 14, wherein the active corrosion barrier is a conversion coat.
